Europäisches Patentamt

European Patent Office

Office européen des brevets

(19)

(11) Publication number: **0 406 491 A1**

# (12) EUROPEAN PATENT APPLICATION

(21) Application number: 89306896.5

(22) Date of filing: 06.07.89

(51) Int. Cl.5: **H03K 19/003**

(30) Priority: 06.07.88 JP 168185/88

(43) Date of publication of application:
09.01.91 Bulletin 91/02

(84) Designated Contracting States:
DE FR GB

(71) Applicant: **KABUSHIKI KAISHA TOSHIBA**
**72, Horikawa-Cho Saiwai-ku**
**Kawasaki-shi Kanagawa-ken(JP)**

Applicant: **TOSHIBA MICRO-ELECTRONICS**
**CORPORATION**
**25-1, Ekimae-hon-cho**
**Kawasaki-ku Kawasaki-shi**
**Kanagawa-ken(JP)**

(72) Inventor: **Wada, Akira Intellectual Property**
**Division**
**Toshiba Corp. Principal Office 1-1-1,**
**Shibaura**
**Minato-ku Tokyo(JP)**
Inventor: **Uchida, Kazuyuki Intellectual**
**Property Division**
**Toshiba Corp. Principal Office 1-1-1,**
**Shibaura**
**Minato-ku Tokyo(JP)**

(74) Representative: **Freed, Arthur Woolf et al**
**MARKS & CLERK 57-60 Lincoln's Inn**
**Fieldslds**
**London WC2A 3LS(GB)**

(54) Noise removing circuit.

(57) A noise removing circuit has first and second MOS FET circuits (11), (12) which have respectively different circuit threshold levels for inverting the input signal and a third circuit (13), (14) which is responsive to the output signals generated by the first and second MOS FET circuit (11), (12) to remove intermediate noise on the input. The noise removing circuit eliminates the effect of noise at an intermediate level (between the low and high levels) which influences the operation between the circuit threshold level of the first MOS FET circuit (11) and the circuit threshold level of the second MOS FET circuit (12).

EP 0 406 491 A1

# NOISE REMOVING CIRCUIT

## BACKGROUND OF THE INVENTION

The present invention relates to a noise removing or filtering circuit, which is operable at high speed with low current consumption.

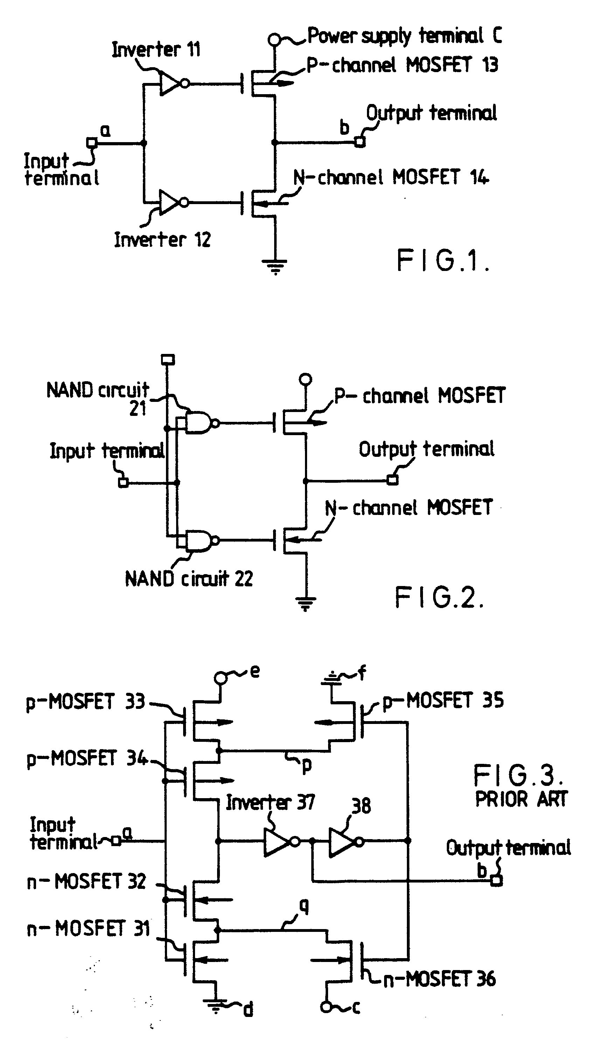

Conventionally, Schmitt circuits are known which function to remove noise. Fig. 3 shows such a Schmitt circuit. Two p-channel MOS Field Effect Transistors (FET) 33 and 34 having a common input gate a are connected in parallel at node p, and two n-channel MOS FETs 31 and 32 also having the common input gate a are connected at node q. A p-channel MOS FET 35 is connected between junction point p of the two p-channel MOS FETs 33 and 34 and ground. An n-channel MOS FET 36 is connected between junction point q of the two n-channel MOS FETs 31 and 32 and a power supply voltage c. Two series-connected inverters 37 and 38 are serially connected between a junction point of the two parallel-connected p-channel MOS FET 34 and n-channel MOS FET 32 and gates of the two FETs 35 and 36 with an output terminal b connected at the connecting junction of the two inverters.

The operation of the Schmitt circuit shown in Fig. 3 will be described with respect to its function of eliminating noise in the input signals.

While an input signal is changing from a low (L) voltage level to a high (H) voltage level at the input terminal a, there exists a state where the n-channel MOS FET 31 and the n-channel MOS FET 36 are both turned on, so that a DC current path is generated between the power supply terminal c and ground d. As a result, the potential at node point q drops thereby lowering the threshold of the entire circuit. While the input signal is changing from the L level to the H level at the input terminal a, there exists another state at a higher input signal level where the p-channel MOS FET 33 and the p-channel MOS FET 35 are both turned on, so that a DC current path is generated between the power supply terminal e and ground f thereby raising the threshold of the entire circuit.

As described above, since the circuit threshold goes down when the input signal level is low, noise at intermediate levels (higher than the low level) is cut off. On the other hand, since the circuit threshold rises when the input signal level is high, noise at intermediate levels (lower than the high level) is cut off. Therefore, noise is eliminated from the output signal without causing erroneous operation.

In the prior-art circuit, as described above, the change in circuit threshold required for securing a hysteresis effect is controlled by providing a DC path between power supply terminals as shown in Fig. 3, in order to provide a noise filtering function.

However, since a DC path is formed between the power supply terminals, current flows through the low-resistance MOS transistors, thus resulting in an increase in current consumption. In addition, even when an input signal having no noise changes instantaneously, there exists a problem since a DC path is formed between the power supply terminals, and a delay is produced; the output response speed is slow and therefore the circuit is not usable to process high speed signals.

Further, the circuit design is difficult using the Schmitt circuit because it is difficult to establish the proper hysteresis width and other circuit constants.

## SUMMARY OF THE INVENTION

It is an object of the present invention to provide a noise removing or filtering circuit which is operable at high speed with low current consumption.

The present invention provides a noise removing circuit comprising first and second logic circuits having a primary input terminal. A third MOS logic circuit comprises a p-channel MOS FET having a source to which a first potential is supplied and an n-channel MOS FET having a source to which a second potential is supplied. The output of the first logic circuit is connected to the gate of the p-channel MOS FET, and the output of the second logic circuit is connected to the gate of the n-channel MOS FET. A junction point between the drain of the p-channel MOS FET and the drain of the n-channel MOS FET is the primary output of the circuit. The circuit threshold to the input signal of the first logic circuit is higher than that of the second logic circuit and removes intermediate level noise included in the input signal.

In the preferred embodiment of the present invention, the output of the first logic circuit, which has a higher circuit threshold, is connected to the gate of the p-channel MOS FET; and the output of the second logic circuit, which has a lower circuit threshold, is connected to the gate of the n-channel MOS FET.

When a signal which includes noise, that is, a signal of intermediate level, is input, either the first or second logic circuit is activated, so that both the p-channel MOS FETS and the n-channel MOS FET are turned on or off in relation to the power supply voltage. This state is dynamically held immediately before the voltage level changes. Therefore, as long as the input voltage does not go above the high level or below the low level, the original output level is maintained. Therefore, when the input voltage returns to the original low level, the output from the output terminal is maintained at the original level. As described above, the noise-removing circuit achieves the noise-removal function at low power levels.

BRIEF DESCRIPTION OF THE DRAWINGS

Fig. 1 is a circuit diagram showing one embodiment of the noise-removing circuit of the present invention.
Fig. 2 is a circuit diagram showing another embodiment of the present invention.
Fig. 3 is a circuit diagram showing a prior-art circuit.
Fig. 4 is a circuit diagram of the circuit used for noise characteristic measurement for comparing the prior-art circuit and the circuit of the present invention.
Fig. 5 is a waveform diagram showing the noise characteristics of the present invention compared with the prior art.

DETAILED DESCRIPTION OF THE PREFERRED EMBODIMENTS

The present invention will be described in detail with reference to the drawings.

Fig. 1 is a circuit diagram showing one embodiment of the present invention.

This circuit comprises a first logic circuit, here shown as inverter 11, and a second logic circuit, here shown as inverter 12, both having a common input at terminal a . A third MOS logic circuit comprises a p-channel MOS FET 13 having its source connected to a high level power supply terminal c and an n-channel MOS FET 14 having its source grounded. The output of the inverter 11 is connected to the gate of the p-channel MOS FET 13, and the output of the inverter 12 is connected to the gate of the n-channel MOS FET 14. A junction point between the drain of the p-channel MOS FET 13 and the drain of the n-channel MOS FET 14 is output terminal b . Terminal b is connected to another circuit not shown here.

In this circuit, according to the present invention, the voltage threshold of the inverter 11 is higher than that of the inverter 12.

The operation of the noise-removing circuit shown in Fig. 1 will now be described.

When a low level voltage is applied to the input terminal a , the outputs of the two inverters 11 and 12 are both inverted, so that both outputs are at a high level. This high level signal is input to the gate of the p-channel MOS FET 13, so that it is turned off. The high level signal is also applied to the gate of the n-channel MOS FET 14, so that it is turned on. Therefore, the output terminal b outputs a low level signal.

When the input voltage rises a small amount above the low level voltage state and exceeds the lower circuit threshold of inverter 12, the output of inverter 12 with the lower circuit threshold is inverted. The low level voltage obtained immediately before the inversion is dynamically held at the output b , since the p-channel MOS FET 13 and the n-channel MOS FET 14 are both turned off.

As long as the input voltage does not exceed the higher circuit threshold of inverter 11, the low level is maintained at the output b . Therefore, if the input voltage returns to the original low level, the low level output is maintained in spite of the fact that the input voltage rises to an intermediate level, for instance because of noise on the input signal.

When the input voltage exceeds the higher circuit threshold of inverter 11 the output of inverter 11 is inverted to turn on the p-channel MOS FET 13. At this time, the n-channel MOS FET 14 is OFF, as already described above. The high level signal is then output from the output terminal b .

Therefore, the input circuit threshold obtained when seen from the output b , is roughly equal to the circuit threshold of the inverter 11.

When the high level signal is applied to the input terminal a , the outputs of the two inverters 11 and 12 are both inverted to the low level. Since this low level is input to the gate of the p-channel MOS FET 13, the p-channel MOS FET 13 is turned on. On the other hand, this low level is also input to the gate of the n-channel MOS FET 14, turning it off. Therefore, the output of the high level signal is maintained at the output terminal b .

When the input voltage is lowered a small amount from the high level voltage and drops below the high circuit threshold, the output of the inverter 11 with the higher circuit threshold is inverted. The high level voltage obtained immediately before the inversion is dynamically held at the output b , since the p-channel MOS FET 13 and the n-channel MOS FET 14 are both turned off.

As long as the input voltage does not drop below the lower circuit threshold, the high level is maintained at the output b . If the input voltage returns to the original high level, the high level output is maintained despite the fact that the input voltage had dropped a small amount to an intermediate level.

When the input voltage drops below the lower circuit threshold down to the low level, the output of inverter 12 is inverted. The n-channel MOS FET 14 is turned on and the p-channel MOS FET 13 is turned off so that the low level signal is output from the output terminal b .

As described above, the input circuit threshold obtained when seen from the output b , is roughly equal to the circuit threshold of the inverter 12.

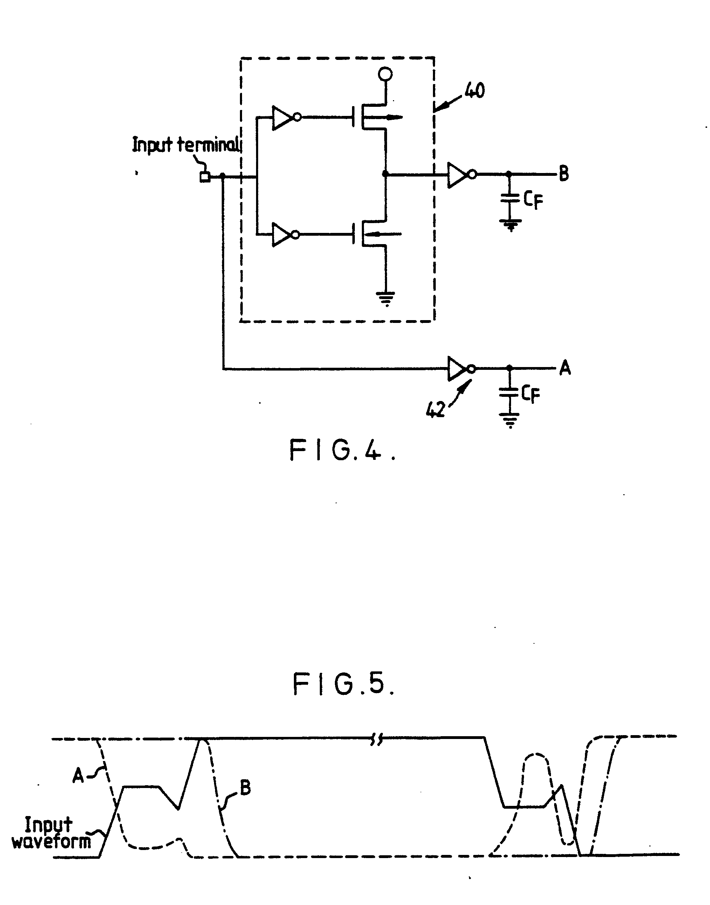

Fig. 5 shows the operating waveforms (noise characteristics) obtained when an input signal which has noise superimposed on it is applied to an input terminal a of a circuit. Waveform A shows the output of a circuit which has no noise removal capability. Waveform B shows the output of a circuit of the present invention. Both such circuits are shown in Fig. 4. The prior art circuit with the output taken at A is an inverter 42 without any means for removing noise. The same input signal is also applied to circuit 40 which is arranged in accordance with the invention.

As can be understood by Fig. 5, the output signal A is inverted relative to the input signal, but is effected by noise. However, the output signal B is not subjected to the influence of noise in circuit 40.

Without being limited to the above embodiment, the present invention can be modified into various modifications within the scope of the invention. For instance, as shown in Fig. 2, it is possible to use two NAND circuits 21 and 22 as the logic circuits. Such a circuit is equivalent to that of Fig. 1.

The noise removing circuit of the present invention provides the following advantages. Since there exists no DC path between the power supply terminals as in the prior-art Schmitt circuit, high speed operation is enabled with low current consumption. Therefore, the circuit of the present invention can be applied to signals such as clock signals, for which delay raises serious problems. The circuit of the present invention is advantageous over the prior art-circuit.

Further, since the circuit configuration is simple when compared to the conventional Schmitt circuit, it is possible to simplify the determination of the circuit constants, thus enabling highly reliable circuit design.

## Claims

1. A noise removing circuit have a primary input terminal for receiving an input signal and a primary output terminal for outputting an output signal, characterized by comprising a first MOS circuit (11) connected to said primary input terminal (12) and having first output terminal for outputting a first output signal when said signal level is greater than a threshold level of said first MOS logic circuit (11) and for outputting a second output signal when said input signal level is less than said threshold level of said first MOS logic circuit (11); a second MOS logic circuit (12) connected to said primary input terminal (a) and having second output terminal for outputting said first output signal when said input signal level is greater than a threshold level of said second MOS circuit (12) and for outputting said second output signal when said input signal level is less than said threshold level of said second MOS logic circuit (12); and a third MOS logic circuit (13), (14) connected to said first and second output terminals and to said primary output terminal (b) of said noise removing circuit, said third MOS logic (13), (14) providing a third output signal to said primary output terminal when said input signal level provided to said primary input terminal (a) is greater than said threshold level of said first MOS logic circuit (11), providing a fourth output signal to said primary output terminal (b) when said input signal level provided for said primary input terminal (a) is less than said threshold level of said second MOS logic circuit (12), and providing respectively said third or fourth output signal hold dynamically at said primary output terminal (b) before the input signal level changes when said input signal level provided to said primary input terminal (a) changes less than said threshold level of said first MOS logic circuit (11) and greater than said threshold level of said second MOS logic circuit (12); wherein said threshold level of said first MOS logic circuit (11) is higher than threshold level of said second MOS logic circuit (12).

2. The noise removing circuit of Claim 1, characterized in that said first MOS logic circuit is a first inverter (11) and the second MOS logic circuit (12) is a second inverter.

3. The noise removing circuit of Claim 1, characterized in that said first MOS logic circuit (11) includes a first NAND gate (21) and said second MOS circuit (12) includes a second NAND gate (22).

4. The noise removing circuit of Claim 1, characterized in that the third MOS logic circuit (13), (14) includes first and second FETs (13), (14).

5. The noise removing circuit of Claim 4, characterized in that the first FET is a p-channel MOS FET (13) and the second FET is an n-channel MOS FET (14).

6. A noise removing circuit having a primary input terminal (a) for receiving an input signal and a primary output terminal (b) for output signal, characterized by comprising a first MOS logic circuit (11) connected to said primary input terminal (a), and having a first circuit threshold; a second logic circuit (12) connected to said common input terminal (a), and having a second circuit threshold; a p-channel MOS FET (13) having a source (c) to which a first potential is supplied, said first MOS logic circuit (11) being connected to a gate of said p-channel MOS FET; an n-channel MOS FET (14) having a source to which a second potential is supplied, said second MOS logic circuit (12) being connected to a gate of said n-channel MOS FET; said primary output terminal (b) being connected in common to the respective drains of said p-channel and n-channel MOS FET; and wherein said first circuit threshold of said first MOS logic circuit is higher than said second circuit threshold of said second MOS logic circuit so as to remove noise included in said input signal intermediate said first circuit threshold and said second circuit threshold levels.

7. The noise removing circuit of Claim 6, characterized in that said first MOS logic circuit (11) includes a first inverter (11) and said second MOS logic circuit include a second inverter (12).

Inverter 11

Power supply terminal C

P-channel MOSFET 13

Output terminal

a

b

Input terminal

N-channel MOSFET 14

Inverter 12

FIG.1.

NAND circuit 21

P-channel MOSFET

Input terminal

Output terminal

N-channel MOSFET

NAND circuit 22

FIG.2.

e

f

p-MOSFET 33

p-MOSFET 35

p-MOSFET 34

p

FIG.3.
PRIOR ART

Input terminal a

Inverter 37

38

Output terminal

b

n-MOSFET 32

n-MOSFET 31

q

n-MOSFET 36

d

c

6

FIG.4.

FIG.5.

7

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | PATENT ABSTRACTS OF JAPAN, vol. 12, no. 130 (E-603)[2977], 21st April 1988; & JP-A-62 254 521 (MITSUBISHI ELECTRIC CORP.) 06-11-1987 --- | 1,2,4-7 | H 03 K 19/003 |
| X | PATENT ABSTRACTS OF JAPAN, vol. 12, no. 351 (E-660)[3198], 20th September 1988; & JP-A-63 107 224 (NEC CORP.) 12-05-1988 --- | 1,2,4-7 | |
| X | PATENT ABSTRACTS OF JAPAN, vol. 9, no. 248 (E-347)[1971], 4th October 1985; & JP-A-60 97 726 (MITSUBISHI DENKI K.K.) 31-05-1985 --- | 1,2,4-7 | |
| X | DE-A-2 737 544 (SIEMENS AG) * Figure 2; page 4, lines 16-25 * ----- | 1,2,4-7 | |
| | | | TECHNICAL FIELDS SEARCHED (Int. Cl.5) |
| | | | H 03 K |

The present search report has been drawn up for all claims

| Place of search | Date of completion of the search | Examiner |
|---|---|---|
| THE HAGUE | 12-06-1990 | 3916 |

EPO FORM 1503 03.82 (P0401)